(19) Europäisches Patentamt
European Patent Office
Office européen des brevets

(11) EP 0 420 612 B1

(12) **EUROPEAN PATENT SPECIFICATION**

(45) Date of publication and mention
of the grant of the patent:
**03.01.1996 Bulletin 1996/01**

(51) Int Cl.⁶: **H04N 9/64**, H04N 9/04

(21) Application number: **90310535.1**

(22) Date of filing: **26.09.1990**

(54) **Colour television camera**

Farbfernsehkamera

Caméra de télévision en couleurs

(84) Designated Contracting States:
**DE FR GB**

(30) Priority: **26.09.1989 JP 249836/89**
 **25.10.1989 JP 278206/89**

(43) Date of publication of application:
**03.04.1991 Bulletin 1991/14**

(73) Proprietor: **SONY CORPORATION**
**Tokyo (JP)**

(72) Inventors:
 • **Asaida, Takashi**
 **Shinagawa-ku, Tokyo (JP)**
 • **Miyamoto, Kazuyoshi**
 **Shinagawa-ku, Tokyo (JP)**

(74) Representative:
**Ayers, Martyn Lewis Stanley et al**
**London WC1R 5LX (GB)**

(56) References cited:
 **EP-A- 0 068 811**   **EP-A- 0 368 354**
 **FR-A- 2 622 379**

## Description

This invention relates to a color television camera and, more particularly, to a color television camera in which a digital signal processing is performed on output signals of an imaging or image pickup device.

In a conventional solid-state imaging system in which a solid-state image sensor having a discrete pixel structure constituted by charge coupled devices (CCDs) is used in an imaging section, since the solid-state image sensor itself constitutes a sampling system, aliasing components from the spatial sampling frequency fs are mixed in a known manner into image pickup output signals from the solid-state image sensor.

In a color television camera adapted for forming a color image, a two CCD type solid-state imaging apparatus for forming a three prime color image by a solid-state image sensor for forming a green color image and a solid-state image sensor having color coding filters for forming red color and blue color images, or a three CCD type solid-state imaging apparatus for forming a three prime color image by separate solid-state image sensors, have been put to practical use.

A known technique for improving the resolution in the three CCD type solid state imaging apparatus, is the so-called spatial offsetting technique, according to which the solid-state image sensors for forming the red color image and the blue color image are arrayed with an offset equal to one half the spatial pixel sampling period with respect to the solid-state image sensor for forming the green color image. If this spatial offsetting technique is resorted to, it becomes possible with the analog output three CCD solid state imaging apparatus to realize a high resolution surpassing the restrictions imposed by the number of pixels of the solid-state image sensor.

In a color television camera in which output signals of solid state image pickup devices are digitized, the digitizing operation is performed at a clock rate fs which is about four times the color subcarrier frequency fsc (f=4fsc) and, for eliminating adverse effects caused by high harmonics of the color subcarrier frequency fsc, the output frequency band of the composite video signals, obtained upon mixing the luminance signal Y with modulated color difference signal MOD.C, is limited to not more than 2fsc.

The color television camera in which the output signals of the solid state image pickup devices are digitized in known for example from US-A- 4490738.

Meanwhile, for improving the picture quality of the television images, attempts have been made towards increasing the bandwidth of the television signals. However, with the color television camera in which the image pickup output of solid state image sensors having a discrete pixel structure, such as CCDs, the color signal components are restricted unnecessarily, if the output band of the composite video signals is increased to more than 2fsc, with resulting harmonic distortion in the color subcarrier frequency and deterioration in the picture quality.

On the other hand, when digital interfacing for units associated with a D1/D2 format digital video system is loaded on a solid state image pickup system employing the solid state image sensor having the discrete pixel structure, such as CCD, the digital rate is increased excessively if the sampling rate of the digital interface unit is set to 2fs, while the standards for digital interfacing are also not satisfied. In addition, use of the sampling rate for the digital processing system meeting with existing standards, such as D1/D2 format results in deteriorated resolution as compared to the solid state image pickup system dedicated to analog processing in case of using the analog output directly.

It is a principal aim of the present invention to provide a color television camera which meets signal standards for digital video or associated equipment and exhibits a superior modulation transfer function (MTF) while allowing to produce high quality digital composite video signals containing a lesser amount of aliasing components.

It is another aim of the present invention to provide a colour television camera which allows to produce high resolution composite video signals without unnecessarily suppressing colour signals or without concomitant generation of harmonic distortion of the colour sub-carrier waves.

According to the present invention there is provided a colour television camera having image pickup means for outputting three primary colour image pickup signals at a predetermined rate fs, the colour television camera comprising:

analog/digital converting means for digitising output signals from the image pickup means at a clock rate equal to the rate fs,

first rate converting means for interpolating and converting output signals from the analog/digital converting means into three primary colour digital image pickup signals having a rate equal to 2fs which is twice the rate fs, and

luminance signal forming means supplied with the output signals of the first rate converting means and adapted for forming a 2fs rate digital luminance signal from the 2fs rate three prime colour digital image pickup signal, characterised by:

colour difference signal forming means supplied with the output signals of the first rate converting means and adapted for forming fs rate digital colour difference signals from the 2fs rate digital three primary colour image pickup signals,

modulating means supplied with output signals from the colour difference signal forming means and adapted for modulating the fs rate digital colour difference signals,

second rate converting means for converting the digital colour difference signals modulated by the modulating means into 2fs rate modulated digital colour difference signals,

composite video signal forming means for forming a 2fs rate digital composite video signal from the 2fs rate digital luminance signal output from the luminance signal forming means and the 2fs rate modulated digital colour difference signals,
digital/analog converting means for converting an output signal from the composite video signal forming means into an analog form, and
a low-pass filter supplied with the output signal from the digital/analog converting means and adapted to pass a signal

component of a frequency lower than the frequency fs.

The present invention also provides a colour television camera having image pickup means for outputting three primary colour image pickup signals at a predetermined rate fs, the colour television camera comprising:

analog/digital converting means for digitising output signals from the image pickup means at a clock rate equal to the rate fs,
first rate converting means for interpolating and converting output signals from the analog/digital converting means into three primary colour image pickup digital signals having a rate equal to 2fs which is twice the rate fs, and
signal processing means supplied with output signals from the first rate converting means and adapted for forming 2fs rate digital composite video signals from the 2fs rate three primary colour image pickup digital signals, characterised by:
a digital low-pass filter supplied with output signals from the signal processing means and adapted for limiting the pass band of the 2fs rate digital composite video signals to fs/2 and
second rate converting means supplied with output signals from said digital low-pass filter and adapted for converting the rate of the pass band limited 2fs rate digital composite video signals to fs.

The present invention will be further described hereinafter with reference to the following description of exemplary embodiments and the accompanying drawings, in which:

Fig. 1 is a block diagram showing an embodiment of a color television camera of the present invention.

Fig. 2 is a diagrammatic view showing a relative array of the solid state image pickup devices of the color television camera shown in Fig. 1.

Figs. 3 A to J are diagrammatic views for illustrating the operation of the color television camera shown in Fig. 1.

Fig. 4 is a chart showing frequency characteristics of an interpolating digital filter used in the color television camera shown in Fig. 1.

Fig. 5 is a chart showing other frequency characteristics of the interpolating digital filter used in the color television camera shown in Fig. 1.

Figs. 6 A to J are diagrammatic views for illustrating the operation of the color television camera of the PAL system to which the present invention is applied.

Fig. 7 is a chart showing frequency characteristics of an interpolating digital filter used in the color television camera of the PAL system to which the present invention is applied.

Fig. 8 is a chart showing other frequency characteristics of the interpolating digital filter used in the color television camera of the PAL system to which the present invention is applied.

Fig. 9 is a block diagram showing a modified embodiment of the color television camera of the present invention.

Fig. 10 is a block diagram showing a detailed construction of a signal processor of the color television camera shown in Fig. 9.

Fig. 11 is a block diagram showing a detailed structure of a color encoder of the color television camera shown in Fig. 9.

Figs. 12 A to I are diagrammatic views for illustrating the operation of the color television camera shown in Fig. 9.

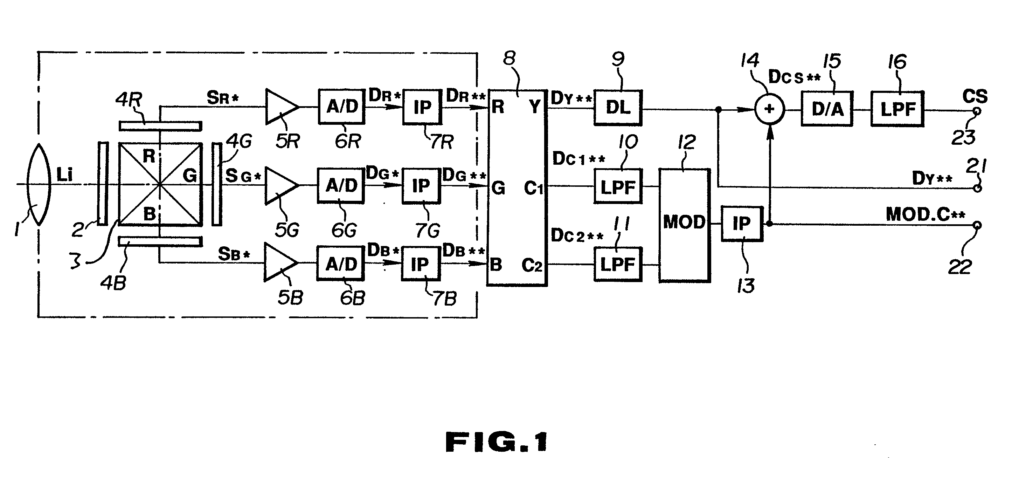

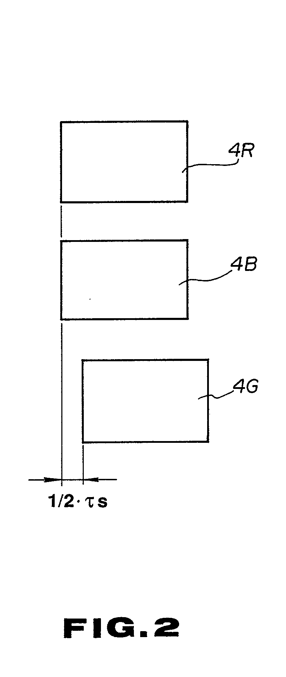

An embodiment of a color television camera apparatus according to the present invention will be hereinafter explained by referring to the accompanying drawings.
The color television camera according to the present invention is constructed as shown in Fig. 1.
The color television camera shown in Fig. 1 is a color television camera of the NTSC system in which the present invention is applied to a three-plate type solid state imaging apparatus in which an imaging light Li incident from an imaging lens 1 via optical low-pass filter 2 is separated by a color separating prism 3 into three prime-color light components for imaging three prime-color images of the object on three CCD image sensors 4R, 4G and 4B.
In the present embodiment, the three CCD image sensors 4R, 4G and 4B constituting an imaging section of the color television camera are so arrayed that the CCD image sensor 4R for imaging the red color image and the CCD image sensor 4B for imaging the blue color image are offset with respect to the CCD image sensor 4G for imaging the green color image by one half the

spatial sampling period $\tau_s$, or $1/2\ \tau_s$, in accordance with the aforementioned spatial offsetting technique, as shown in Fig. 2. The three CCD image sensors 4R, 4G and 4B are driven by a CCD driving circuit, not shown, so that the imaging charges of the pixels are read by read-out clocks of a sampling frequency fs which is equal to four times the color subcarrier frequency fsc, or 4fsc.

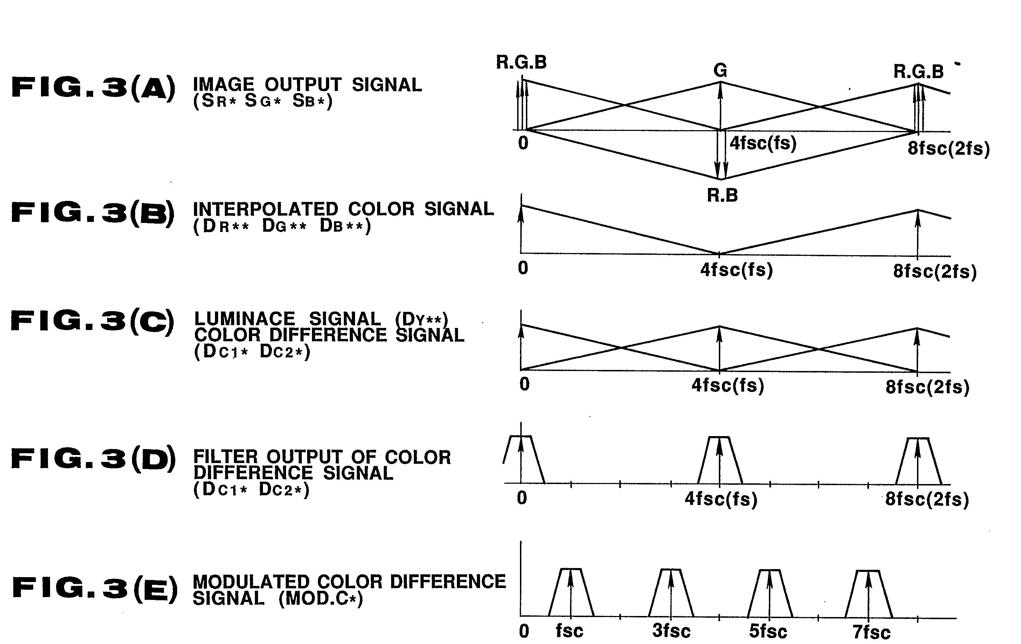

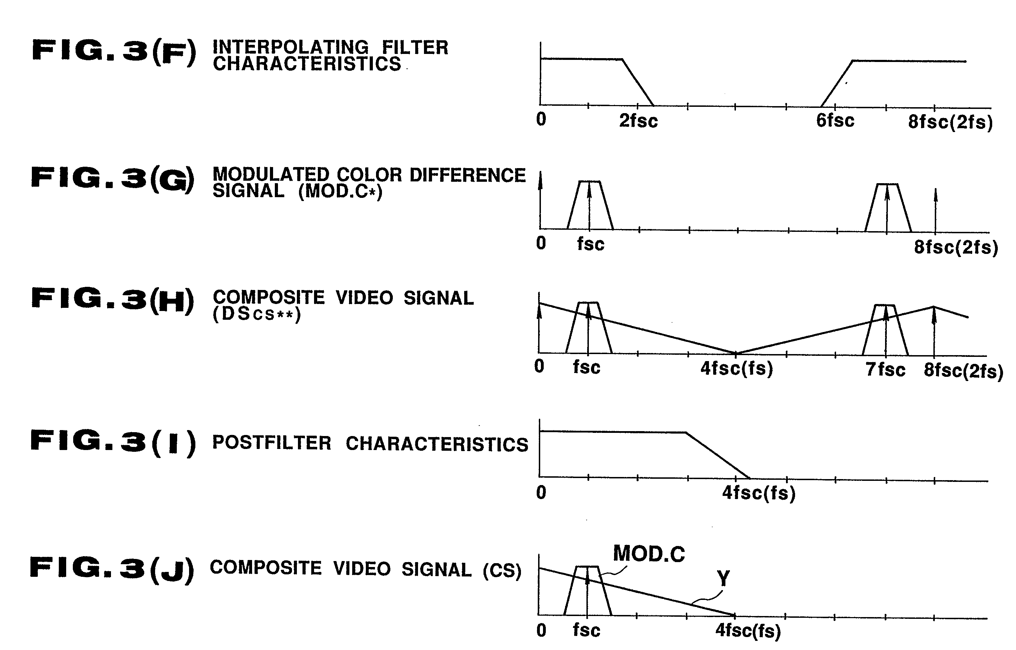

The three-CCD image sensors 4R, 4G and 4B, operating under the principle of the above mentioned spatial offsetting technique, perform spatial sampling of the three prime color images of the object image in such a manner that the CCD image sensor 4G for green color image pickup on one hand and the CCD image sensors 4R and 4B for red color image pickup and blue color image pickup on the other will perform spatial sampling at positions offset from each other by $\tau_s/2$. Thus the component of the sampling frequency fs of the green color image pickup output signal $S_{G*}$ by the CCD image sensor $4_G$ on one hand and the components of the sampling frequency fs of the red color image pickup output signal $S_{R*}$ and the blue color image pickup output signal $S_{B*}$ by the CCD image sensors 4R, 4B, on the other, are in antiphase relative to each other, as may be seen from the signal spectra of the three prime color image pickup output signals $S_{R*}$, $S_{G*}$ and $S_{B*}$ by the CCD image sensors 4R, 4G and 4B, shown at A in Fig. 3.

The image pickup output signals $S_{R*}$, $S_{G*}$ and $S_{B*}$, read out from the CCD image sensors 4R, 4G and 4B by readout clocks of the sampling frequency 4fsc, are transmitted to analog/digital (A/D) converters 6R, 6G and 6B via buffer amplifiers 5R, 5G and 5B, respectively.

Each of these A/D converters 6R, 6G and 6B is supplied, from a timing generator, not shown, with clocks having the clock rate equal to the sampling rate fs of the image pickup output signals $S_{R*}$, $S_{G*}$ and $S_{B*}$, that is the clocks having the clock frequency fs=4fsc equal to that of the readout clocks for the CCD image sensors 4R, 4G and 4B. The A/D converters 6R, 6G and 6B directly digitize the image pickup output signals $S_{R*}$, $S_{G*}$ and $S_{B*}$ at the clock rate fs equal to 4fsc to produce digital color signals $D_{R*}$, $D_{G*}$ and $D_{B*}$ having output spectra which are the same as the spectra of the image pickup output signals $S_{R*}$, $S_{G*}$ and $S_{B*}$ shown at A in Fig. 3.

The digital color signals $D_{R*}$, $D_{G*}$ and $D_{B*}$, obtained at the A/D converters 6R, 6G and 6B, are transmitted interpolating sections 7R, 7G and 7R, respectively.

These interpolating sections 7R, 7G and 7B interpolate the image pickup output signals $S_{R*}$, $S_{G*}$ and $S_{B*}$ of the clock rate fs to produce digital color signals $D_{R**}$, $D_{G*}$ and $D_{B**}$ having a clock rate 2fs which is twice the clock rate fs.

That is, with the present color television camera apparatus, the three CCD image sensors 4R, 4G and 4B, operating under the principle of the spatial offsetting technique, the analog/digital (A/D) converters 6R, 6G and 6B digitizing the image pickup output signals $S_{R*}$, $S_{G*}$ and $S_{B*}$ read out at the sampling rate fs from the CCD image sensors 4R, 4G and 4B at a rate fs equal to the sampling rate fs, and the interpolating sections 7R, 7G and 7B for interpolating the digital color signals $D_{R*}$, $D_{G*}$ and $D_{B*}$ from the A/D converters 6R, 6G and 6B to form the digital color signals $D_{R**}$, $D_{G**}$ and $D_{B**}$ having the clock rate 2fs twice the sampling rate fs, constitute image pickup signal generating means for outputting the digital color signals $D_{R**}$, $D_{G**}$ and $D_{B**}$ as the 2fs rate three prime color digital output signals having the frequency distribution shown at B in Fig. 3.

It will be noted that, although the three prime color image pickup output signals $S_{R*}$, $S_{G*}$ and $S_{B*}$ from the CCD image sensors 4R, 4G and 4B, operating under the principle of spatial offsetting, cannot be put to direct arithmetic operation, since the green color image pickup output signal $S_{G*}$ is phase-offset by $\pi$ from the red color image pickup output signal $S_{R*}$ and the blue color image pickup output signal $S_{B*}$, as described previously. However, these prime color signals are interpolated at the interpolating sections 7R, 7G and 7B into phase-matched 2fs rate digital color signals $D_{R**}$, $D_{G**}$ and $D_{B**}$, which may be put to digital processing by the downstream side processing operation.

Alternatively, the above described image pickup signal generating means may be so implemented that, by using a solid-state image sensor with a number of pixels large enough to assure a high resolution without resorting to spatial offsetting as the image pickup section, the 2fs-rate three prime color image pickup digital output signals may be generated from the A/D converter without the necessity of performing the above mentioned interpolating operation.

The 2fs rate digital color signals $D_{R**}$, $D_{G**}$ and $D_{B**}$ from the interpolating sections 7R, 7G and 7B constituting the image pickup signal generating means are supplied to a matrix circuit 8.

The matrix circuit 8 performs a matrix operation on the 2fs rate digital color signals $D_{R**}$, $D_{G**}$ and $D_{B**}$ to generate a 2fs rate digital luminance signal $D_{Y**}$ and fs rate digital color difference signals $D_{C1*}$ and $D_{C2*}$ in the matrix circuit 8, the 2 fs rate digital color signals $D_{R**}$, $D_{G**}$ and $D_{B**}$ are subjected to downsampling by means of a pre-filter having a zero point at least the frequency fs to produce the fs rate digital color difference signals $D_{C1*}$ and $D_{C2*}$.

The 2fs rate digital luminance signal $D_{Y**}$ is supplied by the matrix circuit 8 to a summation circuit 14 by way of a delay circuit 9 before being outputted at a signal output terminal 21. On the other hand, the 2fs rate digital color signals $D_{R**}$, $D_{G**}$ and $D_{B**}$ are subjected at the matrix circuit 8 to downsampling to form the fs rate digital color difference signals $D_{C1*}$ and $D_{C*2}$, which are supplied to a modulator 12 by way of low-pass filters 10 and 11.

The modulator 12 performs a modulating operation in which the color subcarrier is subjected to orthogonal biaxial modulation by the digital color difference signals $D_{C1*}$ and $D_{C2*}$ having the signal spectrum shown at D in Fig. 3, which color difference signals are supplied from the matrix circuit 8 by way of the low pass filters 10 and 11.

The modulated fs-rate color difference signals MOD.C* from the modulating circuit 12 are modulated color signals exhibiting a frequency distribution containing odd harmonics of the color subcarrier frequency fsc as shown at E in Fig. 3. The modulated fs rate color difference signals MOD.C* from the modulator 11 are supplied by way of a rate converting circuit 13 to the summation circuit 14 while also being outputted at a signal output terminal 22.

It will be noted that the modulated fs-rate color difference signals MOD.C*, produced by the modulator 12, contain odd harmonics of the color subcarrier frequency fsc, as described previously, so that, if the signals MOD.C* remain as they are, the 3fs frequency component thereof will affect the composite video signals.

Thus the rate converting circuit 13 processes the fs-rate modulated color difference signal MOD.C* from the modulator 12 by digital filtering by extracting the fsc frequency component and the 7fs frequency component by the filtering characteristics shown at F in Fig. 3 for generating the modulated color difference signal MOD.C* having the rate 2fs corresponding to the frequency 8fsc and the frequency distribution shown at G in Fig. 3. The rate converting circuit 13 is constituted by a digital filter exhibiting filter characteristics which allow the passage of the color subcarrier frequency fsc and inhibit the passage of the frequency component fs-fsc. The digital filter employed in the rate converting circuit 13 need only be of filter characteristics such that the differential coefficient becomes zero at the frequency fsc and at least one zero point exists in the vicinity of the frequency fs-fsc. In the case of the NTSC system color television camera, as in the present embodiment, such filters having the transfer function $H_1(z)$ given by the formula (1)

$$H_1(z) = \frac{1}{23}(-4_z^{-6} + 12_z^{-4} + 12_z^{-3} + 12_z^{-2} - 4)$$

(1)

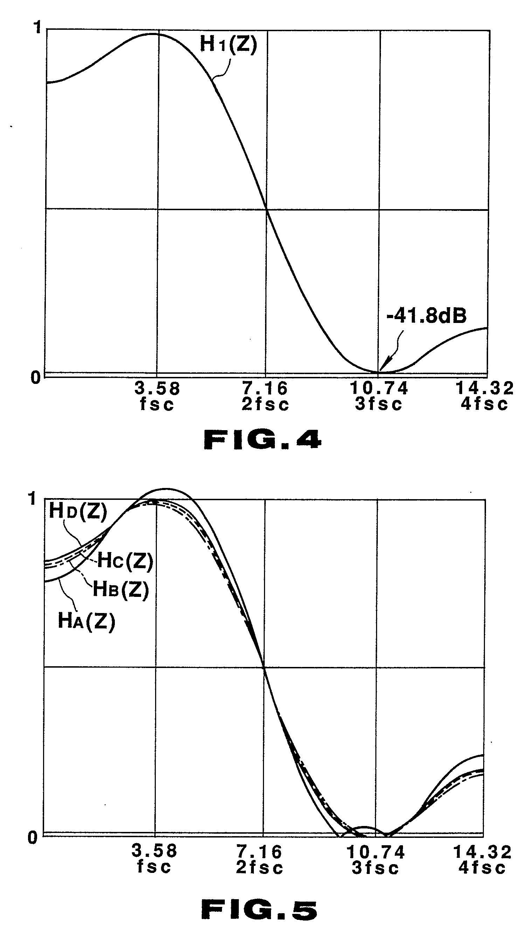

and hence the filter characteristics as shown in Fig. 4, or having the transfer functions $H_{A(z)}$, $H_{B(z)}$, $H_{C(z)}$ or $H_{D(z)}$ given by the formula (2) to (5)

$$H_A(z) = \frac{1}{4}(-_z^{-6} + 2_z^{-4} + 4_z^{-3} + 2_z^{-2} - 1) \qquad (2)$$

$$H_B(z) = \frac{1}{16}(-3_z^{-6} + 8_z^{-4} + 16_z^{-3} + 8_z^{-2} - 3)$$

(3)

$$H_C(z) = \frac{1}{10}(-2_z^{-6} + 5_z^{-4} + 10_z^{-3} + 5_z^{-2} - 2)$$

(4)

$$H_D(z) = \frac{1}{24}(-5_z^{-6} + 12_z^{-4} + 4_z^{-3} + 12_z^{-2} - 5)$$

(5)

and hence the filter characteristics as shown in Fig. 5, may be employed.

The summation circuit 14 sums the 2fs-rate modulated color difference signals MOD.C** from the rate converting circuit 13 to the 2fs-rate digital luminance signal $D_{Y**}$ supplied thereto from the matrix circuit 8 by way of the delay circuit 9 to produce 2fs-rate digital composite video signals $D_{CS**}$ having the frequency distribution shown at H in Fig. 3. These 2fs-rate digital composite video signals $D_{CS**}$ are supplied to the digital/analog (D/A) converter 15.

Meanwhile, the delay circuit 9 provides to the digital luminance signal $D_{Y**}$ a delay corresponding to the processing time necessary to form the 2fs-rate modulated color difference signal MOD.C** from the digital difference signals $D_{C1*}$ and $D_{C2*}$ outputted from the matrix circuit 8.

The 2fs-rate digital composite video signals $D_{CS**}$ are converted by the D/A converter 15 into corresponding analog composite signals of the NTSC system, which are then outputted at signal output terminal 23 by way of a post filter 16 having low-pass filter characteristics shown at I in Fig. 3 to pass the frequency components of approximately 4fc, that is, the frequency components lower than fs.

Since the above mentioned analog composite video signals CS outputted from the signal output terminal 23 have been converted from the 2fs rate digital composite video signals $D_{CS**}$, the bandwidth of the luminance signal Y is enlarged up to the frequency 4fc, or fs, as shown at J in Fig. 3, to provide an image of high resolution.

On the other hand, the 2fs rate modulated color difference signal MOD.C**, generated in the rate converting circuit 13, has been formed by interpolation by a digital filter having filter characteristics which allow the passage of the color subcarrier frequency fsc component and inhibit the passage of the fs-fc frequency component, so that, as shown at G in Fig. 3, it is free from the 3 fsc frequency component. Thus the analog composite video signal CS, formed by converting the 2fs-rate digital composite video signal $D_{CS**}$, obtained by summing the 2fs-rate modulated color difference signal MOD.C** to the 2fs-rate digital luminance signal $D_{Y**}$, into a corresponding analog form, is free from harmonic distortion of the color subcarrier.

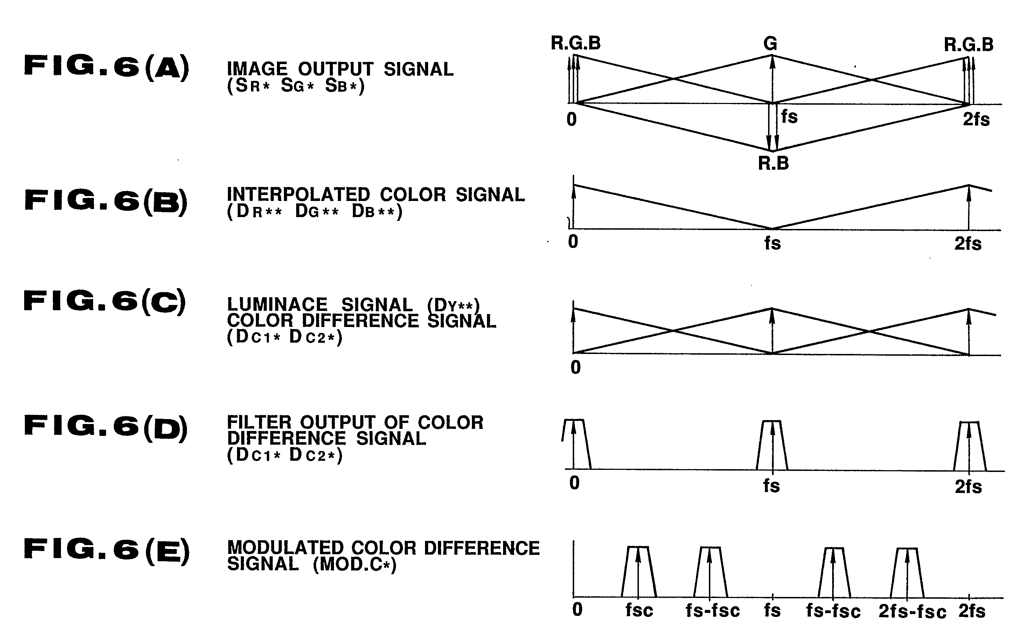

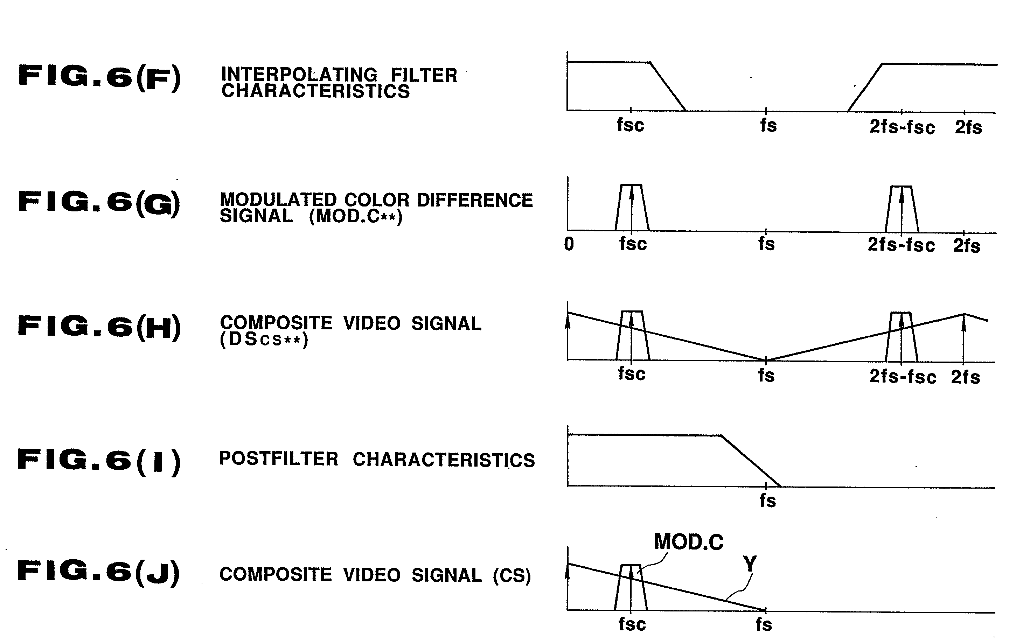

In the above described embodiment in which the present invention is applied to a color television camera of the NTSC system, the 2fs-rate digital composite video signal $D_{CS**}$ is formed by digital processing at the clock rate of 2fs which, with fs=4fsc, corresponds to 8fsc, and the so-formed digital composite video signal $D_{CS**}$ is converted into an analog form to generate the analog composite video signal CS to allow to produce an image of higher resolution free from harmonic distortion of the color subcarrier. However, in the color television camera of the present invention, the sampling frequency fs need not necessarily be a frequency which is an integer multiple of the color subcarrier frequency fsc. Thus the present invention may also be applied to a color television camera of the PAL system as shown in the signal spectrum diagram of Fig. 6 corresponding to the signal spectrum diagram of Fig. 3 to which reference has been made above for explaining the operation of the color television apparatus of the NTSC system.

That is, in the color television camera apparatus of the PAL system, the signal spectrum of the image pickup output signals $S_{R*}$, $S_{G*}$ and $S_{B*}$, read out at the readout clocks of the sampling frequency fs from the CCD image sensors operating under the principle of spatial offsetting, is as shown at A in Fig. 6.

In the present PAL system color television camera apparatus, the sampling frequency fs is set to 908 or 944 times the horizontal scanning frequency $f_H$ in the PAL system, for example instead of to four times the color subcarrier frequency fsc in the PAL system.

The image pickup output signals $s_{R*}$, $s_{G*}$ and $s_{B*}$ are digitized at the rate fs equal to the sampling frequency fs and, by digital interpolation, are converted into 2fs rate digital color signals $D_{R**}$, $D_{G**}$ and $D_{B**}$ having the signal spectrum shown at B in Fig. 6.

From the 2fs-rate digital color signals $D_{R**}$, $D_{G**}$ and $D_{B**}$, 2fs rate digital luminance signals $D_{Y**}$ and fs rate digital color difference signals $D_{C1*}$ and $D_{C2*}$ are produced by matrix operation, as shown at C in Fig. 6.

The fs rate digital color difference signals $D_{C1*}$ and $D_{C2*}$ are freed of frequency components shown at D in Fig. 6 by a chroma filter and the color subcarrier in modulated by PAL system modulating means in accordance with the orthogonal biaxial modulation to produce the fs rate modulated color difference signals MOD.C* having the signal spectrum shown at E in Fig. 6.

The fs rate modulated color difference signal MOD.C* is converted, by a digital interpolation by a digital filter having filter characteristics of inhibiting the fs-fsc frequency component as shown at F in Fig. 6, into a 2fs rate modulated color difference signal MOD.C** having the signal spectrum as shown at G in Fig. 6.

This 2fs rate modulated color difference signal MOD.C** and the aforementioned 2fs rate digital luminance signal are summed together to produce a 2fs digital composite video signal $D_{CS**}$ having the signal spectrum shown at H in Fig. 6.

The 2fs rate digital composite video signal $D_{Cs**}$ is converted by digital/analog converting means into a corresponding analog signal, which is then passed through a post filter having low-pass filter characteristics of passing the frequency components lower than fs as shown at I in Fig. 6 to produce a high resolution analog composite video signal CS of the PAL system which is free from aliasing components and in which the bandwidth of the luminance signal Y has been extended up to fs, as shown at J in Fig. 6.

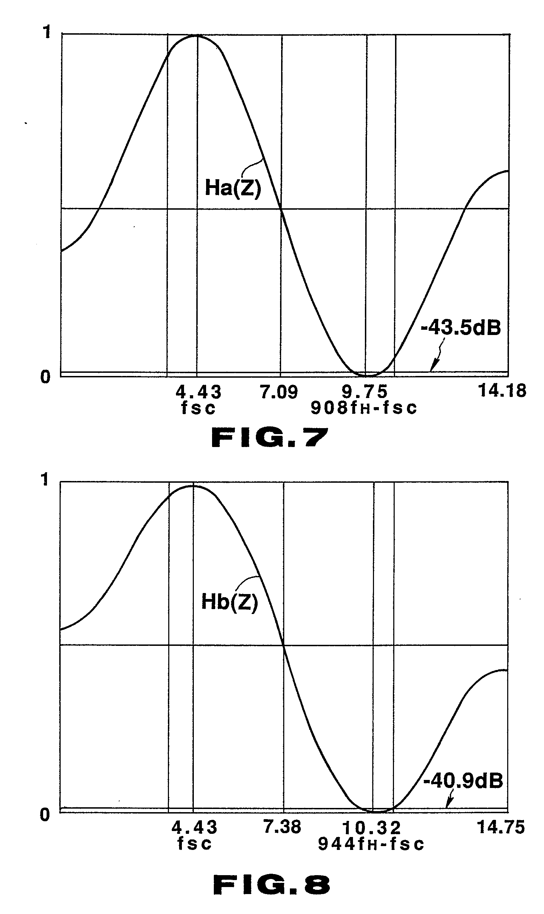

As the digital filter which, when the present invention is applied to the PAL system color television camera, may be used for interpolation as rate converting means for converting the fs rate modulated color difference signals MOD.C** into the 2fs rate modulated color difference signal MOD.C**, such filter may be employed which, with fs=908$f_H$, for example, has filter characteristics shown in Fig. 7 by the transfer function Ha(z) given by the formula (6)

$$H_a(z) = \frac{1}{8} (-3_z^{-6} + 2_z^{-4} + 8_z^{-3} + 2_z^{-2} - 3) \qquad (6)$$

or which, with fs=944$f_H$, has filter characteristics fb shown in Fig. 8 by a transfer function Hb(z) given by

$$H_b(z) = \frac{1}{20} (-6_z^{-6} + 7_z^{-4} + 20_z^{-3} + 7_z^{-2} - 6)$$

(7)

With the above described color television camera apparatus of the present invention, image pickup signal generating means generate the 2 fs rate digital three prime color image pickup signals, which are then transmitted to luminance signal generating means and color difference signal generating means, whereby the digital luminance signal and the digital color difference signal may be formed from the 2fs rate three prime color digital image pickup signals.

The image pickup signal generating means are formed by image pickup sections in which the solid-state image sensor for green color image pickup on one hand and the solid-state image sensors for red color image pickup and blue color image pickup on the other are arrayed with spatial offset equal to one half the pitch of the pixel repetition to improve the resolution by the above mentioned spatial offsetting technique. The three prime color image pickup signal, read out at the sampling rate fs from the solid-state image sensors, are digitized by analog/digital converting means at the clock rate equal to the sampling rate Fs to generate the three prime color digital image pickup output signal, which is then converted by rate conversion and interpolation into 2fs rate three prime color digital image pickup output signal to produce phase-matched 2fs rate three color digital image pickup output signal.

The broad range digital luminance signal may be formed from the 2fs rate three color digital image pickup signal at the luminance signal forming means at a rate equal to 2fs.

The color difference signal generating means processes the 2fs rate three prime color digital image pickup signal from the image pickup signal generating means by down-sampling to the rate fs by means of a pre-filter having a zero point at least the frequency fs to produce the fs-rate digital color difference signal.

The fs-rate modulated color signal produced at the modulating means, supplied with the fs rate digital color difference signal from the color difference signal generating means, is converted by rate converting means into the 2fs rate modulated color difference signal, which are supplied to the composite video signal generating means, where the 2fs rate digital composite video signal may be formed from the 2fs rate digital luminance signal and the 2fs rate modulated color difference signal.

The rate converting means may be constituted by a digital filter having filter characteristics of passing the color subcarrier frequency fsc component and inhibiting the fs-fsc frequency component, such as a digital filter having filter characteristics such that the differential coefficient is approximately zero at the color subcarrier frequency fsc and at least one zero point exists in the vicinity of the frequency fs-fsc, to free the composite video signal of adverse effects by high harmonics of the color subcarrier.

Thus, with the color television camera apparatus according to the present invention, the 2fs rate digital composite video signal is formed from the 2fs rate digital luminance signal and the 2fs rate modulated color difference signal by the composite video signal forming means and the so-formed 2fs rate digital composite video signal is converted into the analog form by digital/analog converting means to produce the analog composite video signal capable of providing a high resolution image which is freed of harmonic distortion of the color subcarrier and in which the bandwidth of the luminance signal has been enlarged to fs.

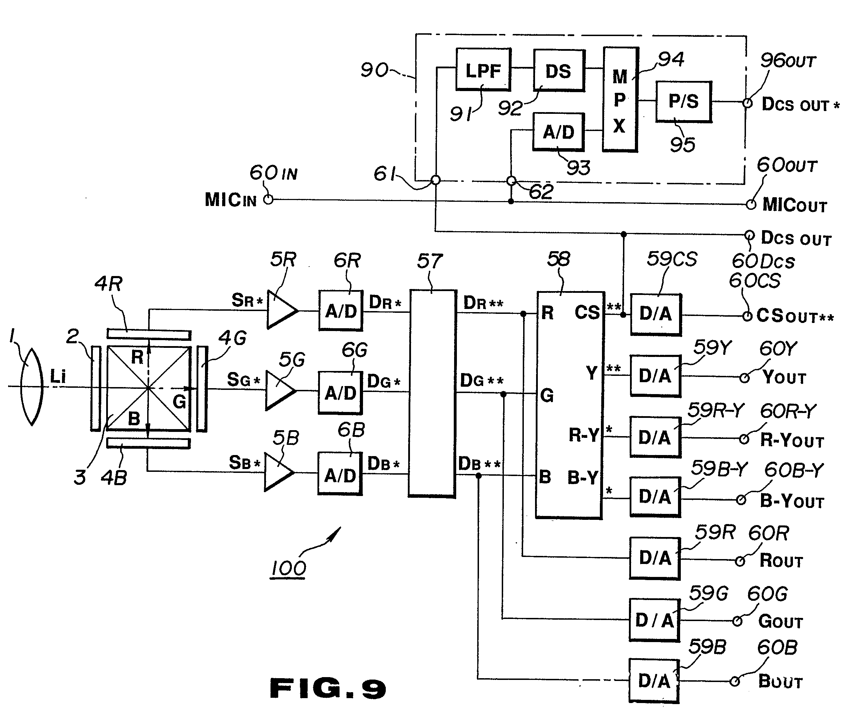

Referring now to Fig. 9, a modified embodiment of the color television camera of the present invention in which video signals of various types may be outputted, will be explained.

Various color data $D_{R^*}$, $D_{G^*}$ and $D_{B^*}$, obtained by the A/D converters 6R, 6G and 6B are supplied, as in the embodiment shown in Fig. 1, to a signal processing section 57.

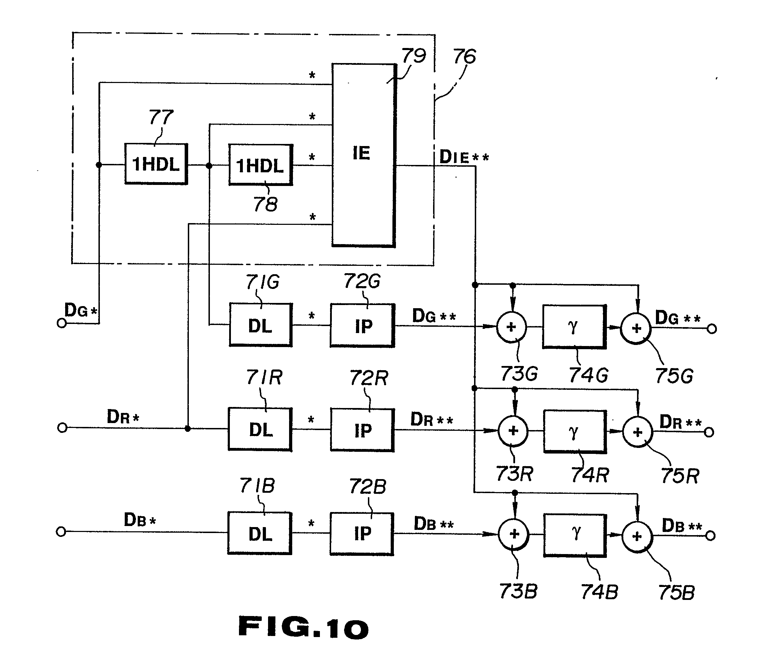

Fig. 10 shows the concrete construction of the signal processing section 57, which is constituted by interpolating sections 72R, 72G and 72B, to which various color data $D_{R^*}$, $D_{G^*}$ and $D_{B^*}$ from the A/D converters 6R, 6G and 6B are supplied by way of delay circuits 71R, 71G and 71B, first summation circuits 73R, 73G and 73B, to which interpolated color data $D_{R^{**}}$, $D_{G^{**}}$ and $D_{B^{**}}$ are supplied from the interpolating section 72R, 72G and 72B, gamma compensating circuits 74R, 74G and 74B to which summation output data are supplied from the first summation circuits 73R, 73G and 73B, second summation circuits 75R, 75G and 75B, to which gamma compensated color data are supplied from these gamma compensation circuits 74R, 74G and 74B and an image enhancement section 76, to which various color data $D_{R^*}$ and $D_{G^*}$ from the A/D converters 6R and 6G are supplied.

The image enhancement section 76 is constituted by a series connection of first and second 1H delay circuits 77 and 78 and an image enhancement data forming circuit 79. Green color data $D_{G^*}$ from the A/D converter 6G are directly supplied to the image enhancement data forming circuit 79. The green color data $D_{G^*}$ are also supplied to the image enhancement data forming circuit 79 by way of the 1H delay circuit 77 and by way of the first and second 1H delay circuits 77 and 78. Red color data $D_{R^*}$ from the A/D converter 6R are also directly supplied to the image enhancement data forming circuit 79. The image enhancement data forming circuit 79 forms, from the color data of the clock rate fs or 4fsc obtained from the A/D converters 6R and 6G, image enhancement data $D_{IE}{}^{**}$ having the clock rate twice the clock rate fs, or the clock rate 2fs, or 8fsc.

The image enhancement data forming circuit 76 transmits the image enhancement data $D_{IE^{**}}$ of the clock rate 2fs, or 8fsc, from the image enhancement data forming circuit 79, to the first summation circuits 73R, 73G and 73B and to the second summation circuits 75R, 75G and 75B.

The interpolating sections 72R, 72G and 72B interpolate the color data $D_{R^*}$, $D_{G^*}$ and $D_{B^*}$ of the clock rate fs or 4fsc from the A/D converters 6R, 6G and 6B to form color data $D_{R^{**}}$, $D_{G^{**}}$ and $D_{B^{**}}$ having the clock rate 2fs or 8fsc which is twice the aforementioned clock rate fs. The interpolating sections 72R, 72G and 72B transmit the 2fs rate color data $D_{R^{**}}$, $D_{G^{**}}$ and $D_{B^{**}}$ to the first summation circuits 73R, 73G and 73B.

The first summation circuits 73R, 73G and 73B operate to sum the 2fs rate image enhancement data $D_{IE^{**}}$ from the image enhancement section 76 to the 2fs rate color signals $D_{R^{**}}$, $D_{G^{**}}$ and $D_{B^{**}}$ from the interpolating sections 72R, 72G and 72B to perform an image enhancement. The first summation circuits 73R, 73G and 73B transmit the image enhanced color data $D_{R^{**}}$, $D_{G^{**}}$ and $D_{B^{**}}$ to the gamma correction circuits 74R, 74G and 74B.

The gamma correction circuits 74R, 74G and 74B perform gamma correction on the image enhanced color data $D_{R^{**}}$, $D_{G^{**}}$ and $D_{B^{**}}$ from the first summation circuits 73R, 73G and 74B and transmit the gamma corrected color data $D_{R^{**}}$, $D_{G^{**}}$ and $D_{B^{**}}$ to the second summation circuit 75R, 75G and 75B.

The second summation circuits 75R, 75G and 75B operate to sum the 2fs rate image enhanced data $D_{IE^{**}}$ from the image enhancement section 76 to the gamma corrected color data $D_{R^{**}}$, $D_{G^{**}}$ and $D_{B^{**}}$ from the gamma correction circuits 74R, 74G and 74B to perform further image enhancement.

The signal processing section 57 thus outputs the gamma corrected and image enhanced 2fs rate color data $D_{R^{**}}$, $D_{G^{**}}$ and $D_{B^{**}}$. These 2fs rate color data $D_{R^{**}}$. $DG^{**}$ and $D_{B^{**}}$, outputted from the signal processing section 57, are supplied to color encoder 58 and to digital/analog converters 59R, 59G and 59B.

The A/D converters 59R, 59G and 59B operate to convert the 2fs rate high resolution color data $D_{R^{**}}$, $D_{G^{**}}$ and $D_{B^{**}}$ from the signal processing section 57 into an analog form to output three prime color image pickup analog output signals $R_{OUT}$, $G_{OUT}$ and $B_{OUT}$ at signal output terminals 60R, 60G and 60B.

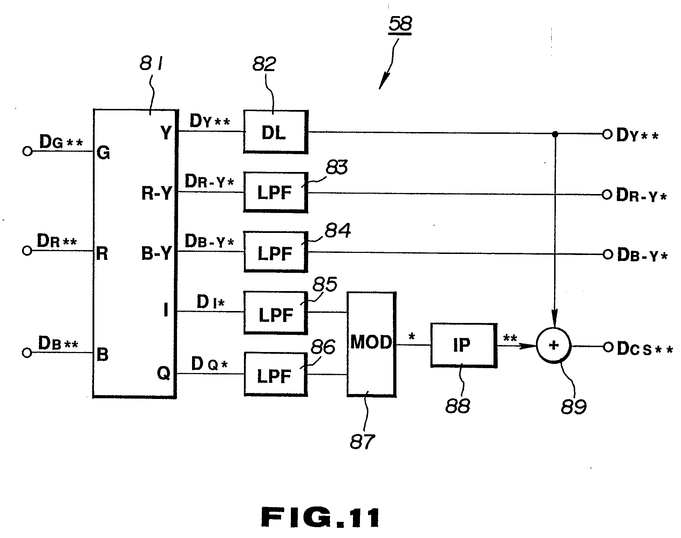

Fig. 11 shows a concrete construction of the color encoder 58 which is constituted by a matrix circuit 81 to which the 2fs rate color data $D_{R^{**}}$, $D_{G^{**}}$ and $D_{B^{**}}$ are supplied from the signal processing section 57, a delay circuit 82 to which luminance signal data $D_{Y^{**}}$ are supplied from the matrix circuit 81, low-pass filters 83, 84, 85 and 86 to which color difference signal data $D_R$-$Y^*$, $D_{B-Y^*}$, $D_{I^*}$ and $D_{Q^*}$ are supplied from the matrix circuit 81, a modulation circuit 87 to which the signal $D_{I^*}$ and $D_{Q^*}$ are supplied from the matrix circuit 81 by way of the low-pass filters 85 and 86, an interpolating circuit 88 to which modulated output data are supplied from the modulating circuit 87, and a summation circuit 89 to which interpolated output data are supplied from the interpolating circuit 88 and also the luminance signal data $D_{Y^{**}}$ from the matrix circuit 81 are supplied by way of the delay circuit 82.

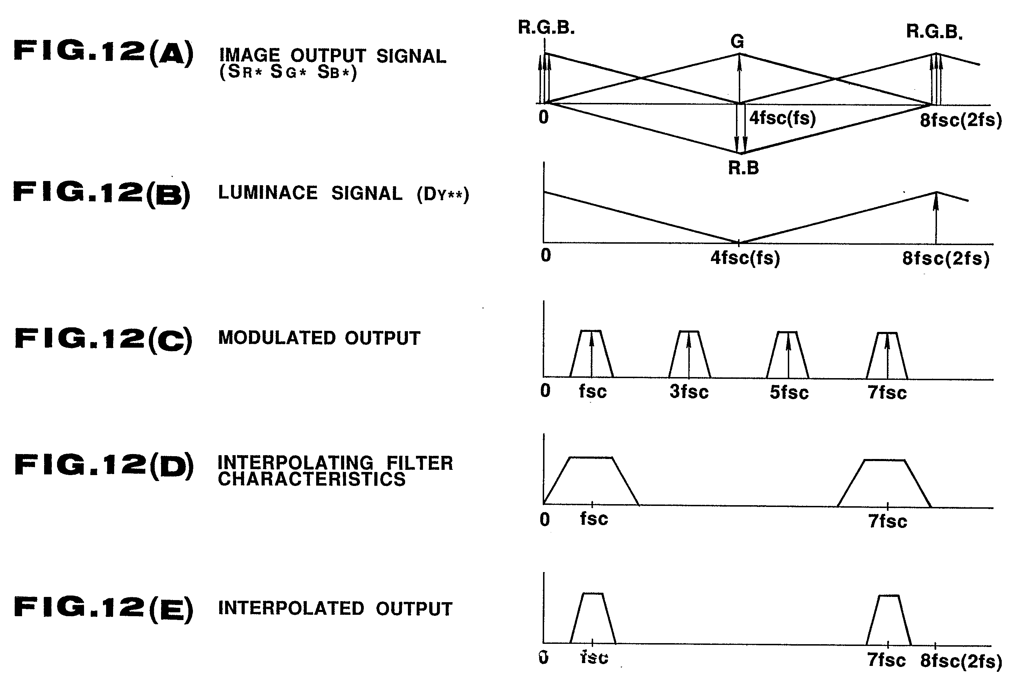

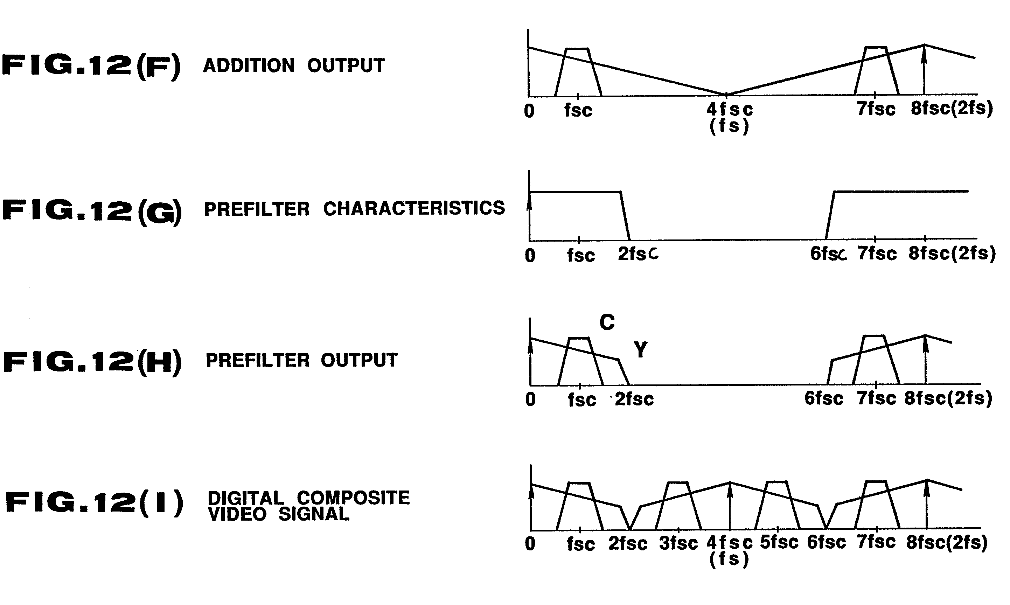

The matrix circuit 81 performs a matrix operation on the 2fs rate color data $D_{R^{**}}$, $D_{G^{**}}$ and $D_{B^{**}}$ to produce the 2fs rate luminance signal data $D_{Y^{**}}$ and the fs rate color difference signal data $D_{R-Y^*}$, $D_{B-Y^*}$, $D_{I^*}$ and $D_{Q^*}$. The 2fs rate luminance signal data $D_{Y^{**}}$, generated in the matrix circuit 81, correspond to luminance signal $Y^{**}$ having a frequency distribution shown at B in Fig. 12. It is noted that the signal spectrum of the three-color image pickup output signals, outputted from the CCD image sensors 4R, 4G and 4B, are shown at A in Fig. 12. The color encoder 58 outputs, as the component color image data for the color data $D_{R^{**}}$, $D_{G^{**}}$ and $D_{B^{**}}$, the luminance signal data $D_{Y^{**}}$ from the matrix circuit 81 by way of delay circuit 82, while outputting the color difference signal data $D_{R-Y^*}$ and $D_{B-Y^*}$ from matrix circuit 81 by way of low pass filters 83 and 84. The delay circuit 82 provides delay characteristics corresponding to the low-pass filters 83 and 84 to the luminance signal data $D_{Y^{**}}$.

In the modulating circuit 87 of the color encoder 58, the signals $D_{I^*}$ and $D_{Q^*}$, supplied from the matrix circuit 81 by way of the low-pass filters 85 and 86, are modulated in accordance with the rectangular biphase modulation. The modulated output data from the modulating circuit 87 correspond to the modulated color difference signal having a frequency distribution containing odd harmonics of the color subcarrier frequency fsc as shown at C in Fig. 12.

The interpolating circuit 88 performs digital filtering on the modulated output data from the modulating circuit 87 for extracting the fsc component and the 7 fsc component by the filtering characteristics shown at D in Fig. 12 to produce 2fs or 8fsc modulated color difference signal data having the frequency distribution shown at E in Fig. 12.

The color encoder 58 operates to sum the luminance signal data $D_{Y^{**}}$, outputted by the matrix circuit 81 by way of the delay circuit 82, to the 2fs rate modulated color difference signal data produced by the interpolating circuit 88, at the summation circuit 89, to produce a digital composite video signal $D_{CS^{**}}$ having the frequency distribution shown at F in Fig. 12.

Thus the color encoder 58, which receives the 2fs rate gamma corrected and image enhanced color data $D_{R^{**}}$, $D_{G^{**}}$ and $D_{B^{**}}$ from the signal processing section 57, outputs component color video data constituted by the 2f rate high resolution luminance signal data $D_{Y^{**}}$ and the fs rate color difference signal data $D_{R-Y^*}$ and $D_{B-Y^*}$, while also outputting 2fs rate high resolution digital composite video signals $D_{CS^{**}}$.

The output component color video data from the color encoder 58, that is the luminance signal data $D_{Y^{**}}$ and the color difference signal data $D_{R-Y^*}$ and $D_{B-Y^*}$, are supplied to digital/analog (D/A) converters 59Y, 59R-Y and 59B-Y.

The D/A converters 59Y, 59R-Y and 59B-Y operate for converting the luminance signal data $DY^{**}$ and the chrominance signal data $D_{R-Y^*}$ and $D_{B-Y^*}$ into the analog form to output the resulting analog component color video signals $Y_{OUT}$, R-$Y_{OUT}$ and B-$Y_{OUT}$ at signal output terminals 60Y, 60R-Y and 60B-Y.

The digital composite video signals $D_{CS^{**}}$, outputted from the color encoder 58, are supplied to digital/analog (D/A) converters 59CS, while being also supplied to signal output terminal 60$D_{CS}$ and first adapter connection terminal 61.

The D/A converter 59CS operates for converting the 2fs rate high resolution digital composite video signals $D_{CS^{**}}$ into an analog form to output the resulting analog composite video signal $C_{SOUT}$ at signal output terminal 60CS.

The color television camera of the present embodiment also has an input terminal 60$_{IN}$ and an output terminal 60$_{OUT}$, both connected to a signal line for voice signals obtained at a microphone, not shown, and a second adapter connection terminal 62.

The present color television camera apparatus also has a camera adapter 90 which is detachably connected and attached to a main camera body 100 adapted for outputting the aforementioned 2fs rate digital composite video signals $D_{CSOUT^{**}}$ at signal output terminal 60$D_{CS}$.

The camera adapter 90 is constituted by a digital low-pass filter 91, supplied with the 2fs rate digital composite video signals $D_{CSOUT^{**}}$ from the main camera body 100 by way of the first adapter connection terminal 61, a rate converting circuit 92, supplied with the digital composite video signals $D_{CSOUT^{**}}$ by way of this digital low-pass filter 91, an analog/digital (A/D) converter 93, supplied with microphone input voice signals from main camera body 100 by way of the second adapter connection terminal 62, a multiplexor circuit 94, adapted for selecting the converted output data from the rate converting circuit 92 or the converted output data from the A/D converter 93, and a parallel/serial (P/S) converter 95 adapted for converting output data from the multiplexor circuit 94 into serial data.

The digital low-pass filter 91 has filter characteristics in which the pass band of the 2fs rate digital composite video signals $D_{CSOUT^{**}}$, supplied thereto from the main camera body 100 by way of the first adapter connection terminal 61, is limited to about less than fs/2, as shown at G in Fig. 12. The rate connecting converter 91 processes the filter output, shown at H in Fig. 12, obtained upon limiting the bandwidth the 2fs rate digital composite video signal $D_{CSOUT^{**}}$ to not more than about fs/2 by the digital low pass filter 91, by downsampling, to produce converted fs rate digital composite video signals $D_{C^-}$

$_{SOUT^*}$shown at I in Fig. 12.

The A/D converter 73 operates for digitizing the microphone input voice signals, supplied from the main camera body 100 via second adapter connection terminal 62, for generating digital voice signal data.

The multiplexor circuit 94 operates for switching between the converted output data from the rate converting circuit 92, that is the fs rate digital composite video signal $D_{CSOUT^*}$, and the converted output data from the A/D converter 93, that is the digital voice signal data, at a predetermined timing, for adding the digital video signal data to the digital composite video signal $D_{CSOUT^*}$. The digital composite video signals D thus added to by the digital voice signal data by the multiplexor circuit 94, are supplied to the P/S converter 95 and thereby converted into serial data which then are outputted at data output terminal $96_{OUT}$.

In the present color television camera, the three color image pickup output signals $S_{R^*}$, $S_{G^*}$ and $S_{B^*}$, read out at the sampling rate fs from the three CCD image sensors 4R, 4G and 4B operating under the principle of the spatial offsetting technique, are digitized at the A/D converters 6R, 6G and 6B at the clock rate equal to the sampling rate fs to produce the color data $D_{R^*}$, $D_{G^*}$ and $D_{B^*}$, which are subjected to image enhancement and gama correction operations at the signal processor 57 operating at the clock rate 2fs twice the clock rate fs. The resulting 2fs rate digital composite video signals $D_{CSOUT^{**}}$, produced at the color encoder 58, are converted by the D/A converter 59CS into corresponding analog signals. In this manner, the high quality analog composite video signals CSOUT having excellent MTF characteristics and containing only a minor amount of aliasing components may be produced at the signal output terminal 60CS of the main camera body 100.

On the other hand in the camera adapter 90 detachably connected and attached to the main camera body 100, the pass band of the 2fs rate digital composite video signals $D_{CSOUT^{**}}$, obtained at the main camera body 100, is limited at the digital low-pass filter 91 to about less than fs/2, and the resulting signals are converted by the rate converting circuit 92 into the fs rate digital composite video signals $D_{CSOUT^*}$. In this manner, the high quality digital composite video signals $D_{CSOUT^*}$ having excellent MTF characteristics and containing only a minor amount of aliasing components may be produced at the data output terminal $96_{OUT}$.

It is noted that, although the digital low pass filter 91 and the rate converting circuit 92, by means of which the 2fs rate digital composite video signals $D_{CSOUT^{**}}$ generated at the main camera body 100 are converted into fs-rate digital composite video signals $D_{CSOUT^*}$, are arranged as the camera adapter 90 and detachably connected to the main camera body 100, the functional block of this camera adapter 90 may also be mounted permanently on the main camera body 100. Also the clock rate fs for A/D conversion may be set to any other frequency than the frequency which is four times the color subcarrier frequency fsc, or 4fsc.

In the above described signal processing circuit of the solid state image pickup apparatus and the color television camera of the present invention, an image output signal with an extremely high picture quality may be produced in which, with the solid-state imaging sensor having the discrete pixel structure performing spatial sampling of the object image as the sub-Nyquist system, the MTF in the frequency range of 0 to fs/2 is improved and aliasing components into the frequency range of 0 to fs/2 by application of the spatial offsetting, and the 2fs rate digital composite video signals can be produced by the digital color encoder.

The pass band of the 2fs rate digital composite video signals from the color encoder is limited by the digital low-pass filter to about less than fs/2, and the resulting signals are converted by the rate converting circuit into fs rate digital composite video signals to produce high-quality digital composite video signals having excellent MTF characteristics and containing only a minor amount of the aliasing components.

In the signal processing circuit of the solid-state image pickup apparatus of the present invention, the digital/analog converting means are provided for converting the 2fsc rate digital composite video signals from the color encoder into an analog form to produce the analog composite video signals to produce the high quality digital composite and analog composite video signals having excellent MTF characteristics and containing only a minor amount of aliasing components.

## Claims

1. A colour television camera having image pickup means for outputting three primary colour image pickup signals at a predetermined rate fs, said colour television camera comprising:

analog/digital converting means (6R,6G,6B) for digitising output signals from said image pickup means at a clock rate equal to said rate fs, first rate converting means (7R,7G,7B) for interpolating and converting output signals (DR*,DR*,DB*) from said analog/digital converting means into three primary colour digital image pickup signals (DR**,DG**,DB**) having a rate equal to 2fs which is twice the rate (fs) and luminance signal forming means (8) supplied with the output signals of said first rate converting means and adapted for forming a 2fs rate digital luminance signal (DY**) from the 2fs rate three prime colour digital image pickup signal, characterised by:

colour difference signal forming means (8) supplied with the output signals of said first rate converting means and adapted for forming fs rate digital colour difference signals (DC1**,DC2**) from said 2fs rate digital three primary colour image pickup signals,

modulating means (12) supplied with output signals from said colour difference signal forming means and adapted for modulating said fs rate digital colour difference signals,

second rate converting means (13) for converting said digital colour difference signals modulated by said modulating means into 2fs rate modulated digital colour difference signals (MOD-C**),

composite video signal forming means (14) for forming a 2fs rate digital composite video signal (DCS**) from said 2fs rate digital luminance signal output from said luminance signal forming means and said 2fs rate modulated digital colour difference signals,

digital/analog converting means (15) for converting an output signal from said composite video signal forming means into an analog form, and

a low-pass filter (16) supplied with the output signal from said digital/analog converting means (15) and adapted to pass a signal component (CS) of a frequency lower than said frequency fs.

2. A colour television camera according to claim 1, wherein said colour difference signal forming means (8) samples down the 2fs rate three primary colour digital image pickup signals (DR**,DG**,DB**) output from said first rate converting means to the fs rate by means of a pre-filter having a zero point at least the frequency fs for forming the fs rate digital colour difference signal.

3. A colour television camera according to claim 1 or 2 wherein said second rate converting means (13) is constituted by a digital filter allowing to pass an fsc component and inhibiting the fs-fsc component of the colour subcarrier frequency.

4. A colour television camera according to claim 1 or 2, wherein said second rate converting means is constituted by a digital filter having a nearly zero differential coefficient at the colour subcarrier frequency fsc and having at least one zero point in the vicinity of the fs-fsc frequency.

5. A colour television camera having image pickup means (4R,4G,4B) for outputting three primary colour image pickup signals (5R*,5G*,5B*) at a predetermined rate fs, said colour television camera comprising:

analog/digital converting means (6R,6G,6B) for digitising output signals from said image pickup means at a clock rate equal to said rate fs,

first rate converting means (57) for interpolating and converting output signals from said analog/digital converting means into three primary colour image pickup digital signals (DR**,DG**,DB**) having a rate equal to 2fs which is twice the rate fs, and

signal processing means (58) supplied with output signals from said first rate converting means and adapted for forming 2fs rate digital composite video signals (CS**) from the 2fs rate three primary colour image pickup digital signals, characterised by:

a digital low-pass filter (91) supplied with output signals from said signal processing means (CS**) and adapted for limiting the pass band of said 2fs rate digital composite video signals to fs/2, and

second rate-converting means (92) supplied with output signals of said digital low-pass filter and adapted for converting the rate of the pass band limited 2fs rate digital composite video signals to fs.

6. A colour television camera according to claim 5 further comprising first digital/analog converter means (59CS) supplied with an output signal of said signal processing means and adapted for converting the 2fs rate digital composite video signal (CS**) into an analog form for outputting an analog composite video signal (CSOUT**).

7. A colour television camera according to claim 5 or 6 comprising a camera part (100) and an adaptor part (90) detachably mounted on said camera part, wherein

said camera part includes said analog/digital converting means (6R,6G,6B), said first rate converting means (57) and said signal processing means (58); and

said adapter part includes said digital low-pass filter (91) and said second rate converting means (92)

8. A colour television camera according to any one of claims 5 to 7 further comprising:

image enhancement means (76,73R,73G,73B) supplied with output signals from said analog/digital converting means and output signals from said first rate converting means and adapted for performing image enhancement of the three primary colour digital image pickup signals.

9. A colour television camera according to any one of claims 5 to 8 further comprising:

gamma correcting means (74G,74R,74B) supplied with the output signal of said first rate converting means and adapted for performing gamma correction of the three primary colour digital image pickup signals.

10. A colour television camera according to any one of claims 5 to 9 further comprising:

second digital/analog converting means (59R,59D,59B) supplied with the output signals (DR**,DG**,DB**) of said first rate converting means (57) and adapted for converting the 2fs rate three primary colour digital image pickup signals into analog signals.

11. A colour television camera according to any one of claims 5 to 10 wherein said signal processing means (8) generate fs rate digital colour difference signals (R-Y*,B-Y*) from said 2fs rate three primary colour digital image pickup signals.

12. The colour television camera according to claim 9 further comprising:

third digital/analog converting means (59R-Y,59B-Y) for converting the output fs rate digital colour difference signals from said signal processing means into analog signals (R-Y OUT,B-Y OUT).

13. A colour television camera according to any one of claims 5 to 13 further comprising:

a microphone for transducing audio signals (MIC in);
second analog/digital converting means (93) for converting output signals from said microphone into digital voice signals, and
multiplexor means (94) supplied with output signals from said second rate converting means and said second analog/digital converting means and adapted for one of the supplied signals.

14. A colour television camera having image pickup means according to any one of the claims 5 to 13, further comprising:

fourth digital/analog converting means (59Y) for converting the 2fs rate digital luminance output signal (Y**) from said signal processing means into an analog signal (Y OUT).

15. A colour television camera according to any one of the preceding claims wherein said image pickup means include a first solid-state image pick-up element (4R) for imaging a red image, a second solid-state image pickup element (4G) for imaging a green image and a third solid-state image pickup element (4B) for imaging a blue image, said second solid-state image pickup element being offset relative to said first and third solid-state image pickup elements by an amount equal to one half the pixel pitch.

**Patentansprüche**

1. Farbfernsehkamera mit einer Bildabtasteinrichtung zur Ausgabe von drei Primärfarbenabtastsignalen mit einer vorgegebenen Rate fs, wobei die Farbfernsehkamera umfaßt:

eine Analog/Digital-Umsetzungseinrichtung (6R, 6G, 6B) zur Digitalisierung von Ausgangssignalen der Bildabtasteinrichtung mit einer Taktrate, welche gleich der Rate fs ist,

eine erste Ratenumsetzungseinrichtung (7R, 7G, 7B)zur Interpolation und Umsetzung der Ausgangssignale (DR*, DG*, DB*) von der Analog/Digital-Umsetzungseinrichtung in drei digitale Primärfarbenbildabtastsignale (DR**, DG**, DB**) mit einer Rate, welche gleich 2fs ist, welche das zweifache der Rate (fs) ist, und

eine Luminanzsignalausbildungseinrichtung (8), welcher die Ausgangssignale der ersten Ratenumsetzungseinrichtung zugeführt werden, und welche angepaßt ist zur Ausbildung eines digitalen Luminanzsignals (DY**) mit der Rate 2fs aus den drei digitalen Primärfarbenbildabtastsignalen mit der Rate 2fs, gekennzeichnet durch:

eine Farbdifferenzsignalausbildungseinrichtung (8), welcher die Ausgangssignale der ersten Ratenumsetzungseinrichtung zugeführt werden, und welche angepaßt ist zur Ausbildung von digitalen Farbdifferenzsignalen (DC1**, DC2**) mit der Rate fs aus den digitalen drei Primärfarbenbildabtastsignale mit der Rate 2fs,

eine Modulationseinrichtung (12), welcher die Ausgangssignale von der Farbdifferenzsignalausbildungseinrichtung zugeführt werden, und welche angepaßt ist zur Modulation der digitalen Farbdifferenzsignale mit der Rate fs,

eine zweite Ratenumsetzungseinrichtung (13) zur Umsetzung der durch die Modulationseinrichtung modulierten digitalen Farbdifferenzsignale in modulierte digitale Farbdifferenzsignale (MOD-C**) mit der Rate 2fs,

eine Ausbildungseinrichtung (14) für ein zusammengesetztes Videosignal zur Ausbildung eines digitalen zusammengesetzten Videosignals (DCS**) mit der Rate 2fs aus dem digitalen Luminanzsignal mit der Rate 2fs, welches von der Luminanzsignalausbildungseinrichtung ausgegeben worden ist, und aus den modulierten digitalen Farbdifferenzsignalen mit der Rate 2fs,

eine Digital/Analog-Umsetzungseinrichtung (15) zur Umsetzung eines Ausgangssignals von der Ausbildungseinrichtung für ein zusammengesetztes Videosignal in eine analoge Form, und

ein T'iefpaßfilter (16), welchem das Ausgangssignal von der Digital/Analog-Umsetzungseinrichtung (15) zugeführt wird, und welche angepaßt ist, eine Signalkomponente (CS) mit einer Frequenz, welche niedriger als die frequenz fs ist, durchzulassen.

2. Farbfernsehkamera nach Anspruch 1, bei welcher die Farbdifferenzsignalausbildungseinrichtung (8) die drei digitalen Primärfarbenbildabtastsignale (DR**, DG**, DB**), welche von der ersten Ratenumsetzungseinrichtung ausgegeben worden sind, nach unten auf die Rate fs mittels eines Vorfilters mit einem Nullpunkt von mindestens der Frequenz fs zur Ausbildung eines digitalen Farbdifferenzsignals mit der Rate fs abtastet.

3. Farbfernsehkamera nach Anspruch 1 oder 2, bei welcher die zweite Ratenumsetzungseinrichtung (13) durch ein Digitalfilter gebildet wird, welches das Durchlassen einer fsc-Komponente zuläßt und die fs-fsc-Komponente der Frequenz des Farbhilfsträgers verzögert.

4. Farbfernsehkamera nach Anspruch 1 oder 2, bei welcher die zweite Ratenumsetzungseinrichtung durch ein Digitalfilter mit einem Differentialkoeffizienten von annähernd Null für die Frequenz fsc des Farbhilfsträgers und mit mindestens einem Nullpunkt in der Nähe der fs-fsc-Frequenz gebildet wird.

5. Farbfernsehkamera mit einer Bildabtasteinrichtung (4R, 4G, 4B) zur Ausgabe von drei Primärfarbenabtastsignalen (5R*, 5G*, 5B*) mit einer vorgegebenen Rate fs, wobei die Fernsehkamera umfaßt:

eine Analog/Digital-Umsetzungseinrichtung (6R, 6G, 6B) zur Digitalisierung der Ausgangssignale von der Abtastungseinrichtung mit einer Taktrate, welche gleich der rate fs ist,

eine erste Ratenumsetzungseinrichtung (57) zur Interpolation und Umsetzung der Ausgangssignale von der Analog/Digital-Umsetzungseinrichtung in drei digitale Primärfarbenbildabtastsignale (DR**, DG**, DB**) mit einer Rate, welche gleich 2fs ist, welche das zweifache der Rate fs ist, und

eine Signalverarbeitungseinrichtung (58), welcher die Ausgangssignale der ersten Ratenumsetzungseinrichtung zugeführt werden, und welche angepaßt ist zur Ausbildung von digitalen zusammengesetzten Videosignalen (CS**) mit der Rate 2fs aus den drei digitalen Primärfarbenbildabtastsignalen mit der Rate 2fs, gekennzeichnet durch:

ein digitales Tiefpaßfilter (91), welchem die Ausgangssignale (CS**) von der Signalverarbeitungseinrichtung zugeführt werden, und welches angepaßt ist zur Begrenzung des Durchlaßbereichs der digitalen zusammengesetzten Videosignale mit der Rate von 2fs auf fs/2, und

eine zweite Ratenumsetzungseinrichtung (92), welcher die Ausgangssignale des digitalen Tiefpaßfilters zugeführt werden, und welche angepaßt ist zur Umsetzung der Rate der bezüglich des Durchlaßbereichs begrenzten digitalen zusammengesetzten Videosignale mit der Rate 2fs auf fs.

6. Farbfernsehkamera nach Anspruch 5, welche weiterhin eine erste Digital/Analog-Umsetzungseinrichtung (59CS) umfaßt, welcher ein Ausgangssignal der Signalverarbeitungseinrichtung zugeführt wird, und welche angepaßt ist zur Umsetzung des digitalen zusammengesetzten Videosignals (CS**) mit der Rate 2fs in eine analoge Form zur Ausgabe eines analogen zusammengesetzten Videosignals (CSOUT**).

7. Farbfernsehkamera nach Anspruch 5 oder 6, welche ein Kamerateil (100) und ein Adapterteil (90), welches abnehmbar auf dem Kamerateil befestigt ist, umfaßt, wobei

die Kamera die Analog/Digital-Umsetzungseinrichtung (6R, 6G, 6B), die erste Ratenumsetzungseinrichtung (57) und die Signalverarbeitungseinrichtung (58) enthält; und

das Adapterteil das digitale Tiefpaßfilter (91) und die zweite Ratenumsetzungseinrichtung (92) enthält.

8. Farbfernsehkamera nach einem der Ansprüche 5 bis 7, welche weiterhin umfaßt:

eine Bildverbesserungseinrichtung (76, 73R, 73G, 73B), welcher die Ausgangssignale der Analog/Digital-Umsetzungseinrichtung und die Ausgangssignale der ersten Ratenumsetzungseinrichtung zugeführt werden, und welche angepaßt ist zur Durchführung einer Bildverbesserung der drei digitalen Primärfarbenbildabtastsignale.

9. Farbfernsehkamera nach einem der Ansprüche 5 bis 8, welche weiterhin umfaßt:

eine Gamma-Korrektureinrichtung (74G, 74R, 74B), welcher das Ausgangssignal der ersten Ratenumsetzungseinrichtung zugeführt wird, und welche angepaßt ist zur Durchführung einer Gamma-Korrektur der drei digitalen Primärfarbenbildabtastsignale.

10. Farbfernsehkamera nach einem der Ansprüche 5 bis 9, welche weiterhin umfaßt:

eine zweite Digital/Analog-Umsetzungseinrichtung (59R, 59D, 59B), welcher die Ausgangssignale (DR**, DG**, DB**) der ersten Umsetzungseinrichtung (57) zugeführt werden, und welche angepaßt ist zur Umsetzung der drei digitalen Primärfarbenbildabtastsignale in analoge Signale.

11. Farbfernsehkamera nach einem der Ansprüche 5 bis 10, bei welcher die Signalverarbeitungseinrichtung (8) digitale Farbdifferenzsignale (R-Y*, B-Y*) mit der Rate fs aus den drei digitalen Primärfarbenbildabtastsignalen erzeugt.

12. Farbfernsehkamera nach Anspruch 9, welche weiterhin umfaßt:

eine dritte Digital/Analog-Umsetzungseinrichtung (59R-Y, 59B-Y) zur Umsetzung der von der Signalverarbeitungseinrichtung ausgegebenen digitalen Farbdifferenzsignale mit der Rate fs in analoge Signale (R-Y OUT, B-Y OUT).

13. Farbfernsehkamera nach einem der Ansprüche 5 bis 13, welche weiterhin umfaßt:

ein Mikrofon zur Umwandlung von Audiosignalen (MIC in);

eine zweite Analog/Digital-Umsetzungseinrichtung (93) zur Umsetzung der Ausgangssignale von dem Mikrofon in digitale Stimmensignale, und

eine Multiplexeinrichtung (94), welcher Ausgangssignale von der zweiten Ratenumsetzungseinrichtung und der zweiten Analog/Digital-Umsetzungseinrichtung zugeführt werden, und welche für eines der zugeführten Signale angepaßt ist.

14. Farbfernsehkamera mit einer Bildabtasteinrichtung nach einem der ansprüche 5 bis 13, welche weiterhin umfaßt:

eine vierte Digital/Analog-Umsetzungseinrichtung (59Y) zur Umsetzung des digitalen Luminanzsignals (Y**) mit der Rate 2fs von der Signalverarbeitungseinrichtung in ein analoges Signal (Y OUT) .

15. Farbfernsehkamera nach einem der vorhergehenden Ansprüchen, bei welcher die Bildabtasteinrichtung ein erstes Festkörper-Bildabtastelement (4R) zur Abbildung eines roten Bildes, ein zweites Festkörper-Bildabtastelement (4G) zur Abbildung eines grünen Bildes und ein drittes Festkörper-Bildabtastelement (4B) zur Abbildung eines blauen Bildes enthält, wobei das zweite Festkörper-Bildabtastelement relativ zu dem ersten und dritten Festkörper-Bildabtastelement um einen Betrag, welcher gleich einem halben Pixelabstand ist, verschoben ist.

## Revendications

1. Caméra de télévision en couleurs ayant un dispositif de prise de vue d'image pour fournir des signaux de prise de vue d'image de trois couleurs primaires à une fréquence prédéterminée fs, ladite caméra de télévision en couleurs comprenant :

des dispositifs de conversion analogique/numérique (6R, 6G et 6B) pour numériser des signaux de sortie dudit dispositif de prise de vue d'image à une fréquence d'horloge égale à ladite fréquence fs,
des premiers dispositifs de conversion de fréquence (7R, 7G et 7B) pour interpoler et convertir des signaux de sortie (DR* DG* et DB*) desdits dispositifs de conversion analogique/numérique en signaux numériques de prise de vue d'image de trois couleurs primaires (DR**, DG** et DB**) ayant une fréquence égale à 2fs qui est le double de la fréquence (fs) et
un dispositif de formation de signal de luminance (8) recevant les signaux de sortie desdits premiers dispositifs de conversion de fréquence et adapté pour former un signal numérique de luminance de fréquence 2fs (DY**) à partir des signaux numériques de prise de vue d'image de trois couleurs primaires de fréquence 2fs, caractérisé par :

un dispositif de formation de signal de différence de couleurs (8) recevant les signaux de sortie desdits premiers dispositifs de conversion de fréquence et adapté pour former des signaux numériques de différence de couleurs de fréquence fs (DC1\*\*, DC2\*\*) à partir desdits signaux numériques de prise de vue d'image de trois couleurs primaires de fréquence 2fs,

un dispositif de modulation (12) recevant des signaux de sortie dudit dispositif de formation de signal de différence de couleurs et adapté pour moduler lesdits signaux numériques de différence de couleurs de fréquence fs,

un second dispositif de conversion de fréquence (13) pour convertir lesdits signaux numériques modulés de différence de couleurs par ledit dispositif de modulation en signaux numériques modulés de différence de couleurs de fréquence 2fs (MOD.C\*\*),

un dispositif de formation de signal vidéo composite (14) pour former un signal vidéo composite numérique de fréquence 2fs (DCS\*\*) à partir dudit signal numérique de luminance de fréquence 2fs fourni par ledit dispositif de formation de signal de luminance et desdits signaux numériques modulés de différence de couleurs de fréquence 2fs,

un dispositif de conversion numérique/analogique (15) pour convertir sous forme analogique un signal de sortie dudit dispositif de formation de signal vidéo composite, et

un filtre passe-bas (16) recevant le signal de sortie dudit dispositif de conversion numérique/analogique (15) et adapté pour passer une composante de signal (CS) d'une fréquence inférieure à ladite fréquence fs.

2. Caméra de télévision en couleurs selon la revendication 1, dans lequel ledit dispositif de formation de signal de différence de couleurs (8) sous-échantillonne les signaux numériques de prise de vue d'image de trois couleurs primaires de fréquence 2fs (DR\*\*, DG\*\*, DB\*\*) fournis par ledit premier dispositif de conversion de fréquence à la fréquence fs au moyen d'un pré-filtre ayant un point nul au moins à la fréquence fs pour former le signal numérique de différence de couleurs de fréquence fs.

3. Caméra de télévision en couleurs selon les revendications 1 ou 2 dans laquelle ledit second dispositif de conversion de fréquence (13) est constitué par un filtre numérique permettant de passer une composante fsc et d'inhiber la composante fs-fsc de la fréquence de sous-porteuse de chrominance.

4. Caméra de télévision en couleurs selon les revendications 1 ou 2, dans laquelle ledit second dispositif de conversion de fréquence est constitué par un filtre numérique ayant un coefficient différentiel presque nul à la fréquence de la sous-porteuse de chrominance fsc et ayant au moins un point nul au voisinage de la fréquence fs-fsc.

5. Caméra de télévision en couleurs ayant un dispositif de prise de vue d'image (4R, 4G et 4B) pour fournir des signaux de prise de vue d'image de trois couleurs primaires (5R\*, 5G\*, 5B\*) à une fréquence prédéterminée fs, ladite caméra de télévision en couleurs comprenant :

des dispositifs de conversion analogique/numérique (6R, 6G, 6B) pour numériser des signaux de sortie dudit dispositif de prise de vue d'image à une fréquence d'horloge égale à ladite fréquence fs,

un premier dispositif de conversion de fréquence (57) pour interpoler et convertir des signaux de sortie desdits dispositifs de conversion analogique/numérique en signaux numériques de prise de vue d'image de trois couleurs primaires (DR\*\*, DG\*\*, DB\*\*) ayant une fréquence égale à 2fs qui est le double de la fréquence fs, et

un dispositif de traitement de signal (58) recevant les signaux de sortie dudit premier dispositif de conversion de fréquence et adapté pour former des signaux vidéo composites numériques de fréquence 2fs (CS\*) à partir des signaux numériques de prise de vue d'image de trois couleurs primaires de fréquence 2fs, caractérisé par :

un filtre numérique passe-bas (91) recevant des signaux de sortie dudit dispositif de traitement de signal (CS\*\*) et adapté pour limiter la bande passante desdits signaux vidéo composites numériques de fréquence 2fs à fs/2, et

un second dispositif de conversion de fréquence (92) recevant des signaux de sortie dudit filtre numérique passe-bas et adapté pour convertir la fréquence des signaux vidéo composites numériques de fréquence 2fs à bande passante limitée à la fréquence fs.

6. Caméra de télévision en couleurs selon la revendication 5 comprenant en outre un premier dispositif de conversion numérique/analogique (59CS) recevant ainsi un signal de sortie dudit dispositif de traitement de signal et adapté pour convertir sous forme analogique le signal vidéo composite numérique de fréquence 2fs (CS\*\*) pour fournir un signal vidéo composite analogique (CSOUT\*\*).

7. Caméra de télévision en couleurs selon la revendication 5 ou 6 comprenant une partie de caméra (100) et une partie d'adaptateur (90) montée de façon détachable sur ladite partie de caméra, de sorte que

ladite partie de caméra comprend ledit dispositif de conversion analogique/numérique (6R, 6G, 6B), ledit premier dispositif de conversion de fréquence (57) et ledit dispositif de traitement de signal (58) ; et

ladite partie d'adaptateur comprend ledit filtre passe-bas (91) et ledit second dispositif de conversion de fréquence (92).

8. Caméra de télévision en couleurs selon l'une quelconque des revendications 5 à 7, comprenant en outre :

des dispositifs d'amélioration d'image (76, 73R, 73G, 73B) recevant des signaux de sortie desdits dispositifs de conversion analogique/numérique et des signaux de sortie dudit premier dispositif de conversion de fréquence et adapté pour réaliser une amélioration d'image des signaux numériques de prise de vue d'image de trois couleurs primaires.

9. Caméra de télévision en couleurs selon l'une quelconque des revendications 5 à 8 comprenant en outre :

des dispositifs de correction de gamma (74G, 74R, 74B) recevant le signal de sortie dudit premier dispositif de conversion de fréquence et adapté pour réaliser une correction de gamma des signaux numériques de prise de vue d'image de trois couleurs primaires.

10. Caméra de télévision en couleurs selon l'une quelconque des revendications 5 à 9 comprenant en outre :

des seconds dispositifs de conversion numérique/analogique (59R, 59G, 59B) recevant les signaux de sortie ($D_{R^{**}}$, $D_{G^{**}}$, $D_{B^{**}}$) dudit premier dispositif de conversion de fréquence (57) et adapté pour convertir les signaux numériques de prise de vue d'image de trois couleurs primaires de fréquence 2fs en signaux analogiques.

11. Caméra de télévision en couleurs selon l'une quelconque des revendications 5 à 10 dans laquelle ledit dispositif de traitement de signal (8) génère des signaux numériques de différence de couleurs de fréquence fs (R-Y*, B-Y*) à partir desdits signaux numériques de prise de vue d'image de trois couleurs primaires de fréquence 2fs.

12. Caméra de télévision en couleurs selon la revendication 9, comprenant en outre :

des troisièmes dispositifs de conversion numérique/analogique (59R-Y, 59B-Y) pour convertir la sortie des signaux numériques de différence de couleurs de fréquence fs dudit dispositif de traitement de signal en signaux analogiques (R-Y OUT, B-Y OUT).

13. Caméra de télévision en couleurs selon l'une quelconque des revendications 5 à 13 comprenant en outre:

un microphone pour une transduction des signaux audio (MIC in);

un second dispositif de conversion analogique/numérique (93) pour convertir des signaux de sortie dudit microphone en signaux vocaux numériques ; et

un dispositif multiplexeur (94) recevant des signaux de sortie dudit second dispositif de conversion de fréquence et dudit second dispositif de conversion analogique/numérique et adapté pour un des signaux fournis.

14. Caméra de télévision en couleurs ayant un dispositif de prise de vue d'image selon l'une quelconque des revendications 5 à 13, comprenant en outre :

un quatrième dispositif de conversion numérique/analogique (59Y) pour convertir le signal numérique de sortie de luminance de fréquence 2fs (Y**) dudit dispositif de traitement de signal en un signal analogique (Y OUT).

15. Caméra de télévision en couleurs selon l'une quelconque des revendications précédentes dans laquelle ledit dispositif de prise de vue d'image comprend un premier élément de prise de vue d'image à semi-conducteur (4R) pour former une image rouge, un second élément prise de vue d'image à semi-conducteur (4G) pour former une image verte et un troisième élément de prise de vue d'image à semi-conducteur (4B) pour former une image bleue, ledit second élément de prise de vue d'image à semi-conducteur étant décalé par rapport auxdits premier et troisième éléments de prise de vue d'image à semi-conducteur d'une quantité égale à un demi pas de pixel.

**FIG.1**

EP 0 420 612 B1

*4R*

*4B*

*4G*

$1/2 \cdot \tau$ s

# FIG.2

**FIG. 3(A)** IMAGE OUTPUT SIGNAL
($S_{R*}$ $S_{G*}$ $S_{B*}$)

**FIG. 3(B)** INTERPOLATED COLOR SIGNAL
($D_{R**}$ $D_{G**}$ $D_{B**}$)

**FIG. 3(C)** LUMINACE SIGNAL ($D_{Y**}$)
COLOR DIFFERENCE SIGNAL
($D_{C1*}$ $D_{C2*}$)

**FIG. 3(D)** FILTER OUTPUT OF COLOR
DIFFERENCE SIGNAL
($D_{C1*}$ $D_{C2*}$)

**FIG. 3(E)** MODULATED COLOR DIFFERENCE
SIGNAL (MOD.C$_*$)

EP 0 420 612 B1

**FIG. 3(F)** INTERPOLATING FILTER CHARACTERISTICS

2fsc    6fsc    8fsc(2fs)

**FIG. 3(G)** MODULATED COLOR DIFFERENCE SIGNAL (MOD.C*)

fsc    8fsc(2fs)

**FIG. 3(H)** COMPOSITE VIDEO SIGNAL (DScs**)

fsc    4fsc(fs)    7fsc    8fsc(2fs)

**FIG. 3(I)** POSTFILTER CHARACTERISTICS

4fsc(fs)

**FIG. 3(J)** COMPOSITE VIDEO SIGNAL (CS)

MOD.C    Y    fsc    4fsc(fs)

**FIG.4**

**FIG.5**

**FIG. 6(A)** IMAGE OUTPUT SIGNAL
($S_{R*}$ $S_{G*}$ $S_{B*}$)

R.G.B        G        R.G.B

0     fs     2fs

R.B

**FIG. 6(B)** INTERPOLATED COLOR SIGNAL
($D_{R**}$ $D_{G**}$ $D_{B**}$)

0     fs     2fs

**FIG. 6(C)** LUMINACE SIGNAL ($D_{Y**}$)
COLOR DIFFERENCE SIGNAL
($D_{C1*}$ $D_{C2*}$)

0

**FIG. 6(D)** FILTER OUTPUT OF COLOR
DIFFERENCE SIGNAL
($D_{C1*}$ $D_{C2*}$)

0     fs     2fs

**FIG. 6(E)** MODULATED COLOR DIFFERENCE
SIGNAL (MOD.C*)

0   fsc   fs-fsc   fs   fs-fsc   2fs-fsc   2fs

EP 0 420 612 B1

**FIG.6(F)** INTERPOLATING FILTER CHARACTERISTICS

fsc          fs          2fs-fsc   2fs

**FIG.6(G)** MODULATED COLOR DIFFERENCE SIGNAL (MOD.C**)

0    fsc              fs          2fs-fsc   2fs

**FIG.6(H)** COMPOSITE VIDEO SIGNAL (DScs**)

fsc              fs          2fs-fsc   2fs

**FIG.6(I)** POSTFILTER CHARACTERISTICS

fs

**FIG.6(J)** COMPOSITE VIDEO SIGNAL (CS)

MOD.C    Y

fsc          fs

EP 0 420 612 B1

**FIG.7**

**FIG.8**

**FIG.9**

EP 0 420 612 B1

FIG.10

**FIG.11**

**FIG.12(A)** IMAGE OUTPUT SIGNAL
($S_{R*}$ $S_{G*}$ $S_{B*}$)

**FIG.12(B)** LUMINACE SIGNAL ($D_{Y**}$)

**FIG.12(C)** MODULATED OUTPUT

**FIG.12(D)** INTERPOLATING FILTER CHARACTERISTICS

**FIG.12(E)** INTERPOLATED OUTPUT

EP 0 420 612 B1

**FIG.12(F)** ADDITION OUTPUT

0　fsc　4fsc (fs)　7fsc　8fsc(2fs)

**FIG.12(G)** PREFILTER CHARACTERISTICS

0　fsc　2fsc　6fsc　7fsc　8fsc(2fs)

**FIG.12(H)** PREFILTER OUTPUT

C
Y

0　fsc　2fsc　6fsc　7fsc　8fsc(2fs)

**FIG.12(I)** DIGITAL COMPOSITE VIDEO SIGNAL

0　fsc　2fsc　3fsc　4fsc (fs)　5fsc　6fsc　7fsc　8fsc(2fs)

EP 0 420 612 B1